(19) Europäisches Patentamt
European Patent Office
Office européen des brevets

(11) **EP 4 787 487 A1**

(12) **EUROPEAN PATENT APPLICATION**
published in accordance with Art. 153(4) EPC

(43) Date of publication:
**05.08.2026 Bulletin 2026/32**

(21) Application number: **24886380.5**

(22) Date of filing: **01.11.2024**

(51) International Patent Classification (IPC):
*H01M 4/525* $^{(2010.01)}$     *H01M 4/505* $^{(2010.01)}$
*C01G 53/00* $^{(2025.01)}$     *H01M 10/0525* $^{(2010.01)}$
*H01M 4/02* $^{(2006.01)}$

(52) Cooperative Patent Classification (CPC):
**C01G 53/00; C30B 29/22; H01M 4/02; H01M 4/505;
H01M 4/525; H01M 10/052; H01M 10/0525;
Y02E 60/10**

(86) International application number:
**PCT/KR2024/017099**

(87) International publication number:
**WO 2025/095710 (08.05.2025 Gazette 2025/19)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **03.11.2023 KR 20230151125**

(71) Applicant: **LG Chem, Ltd.
Seoul 07336 (KR)**

(72) Inventors:
• **LEE, Jee Ho**
**Daejeon 34122 (KR)**
• **KIM, Min Hoon**
**Daejeon 34122 (KR)**
• **HA, Seoung Chul**
**Daejeon 34122 (KR)**

• **YOU, Min Kyu**
**Daejeon 34122 (KR)**
• **SHIN, Ji A**
**Daejeon 34122 (KR)**
• **LIM, Seung Woo**
**Daejeon 34122 (KR)**
• **SEOK, Eun Jeong**
**Daejeon 34122 (KR)**
• **KIM, Yern Seung**
**Daejeon 34122 (KR)**
• **KIM, Sang Hun**
**Daejeon 34122 (KR)**
• **KIM, Dong Chan**
**Daejeon 34122 (KR)**

(74) Representative: **Hoffmann Eitle
Patent- und Rechtsanwälte PartmbB
Arabellastraße 30
81925 München (DE)**

(54) **CATHODE ACTIVE MATERIAL, MANUFACTURING METHOD THEREFOR, AND CATHODE AND LITHIUM SECONDARY BATTERY COMPRISING SAME**

(57)     The present invention is an invention which relates to a positive electrode active material in which the particle diameter of primary particles is uniform, so that there is a small number of fine particles, and there is little breakage of particles during a fine pulverization process and a roll-pressing process for the manufacture of a lithium secondary battery, and the present invention relates to a positive electrode active material, a preparation method thereof, and a positive electrode and a lithium secondary battery including the positive electrode active material, wherein the positive electrode active material includes a lithium nickel cobalt manganese-based oxide having a nickel content of 50 mol% or greater among all transition metals, and in the form of a single particle composed of 10 or fewer primary particles, and has a polydispersity index (PDI) value of 1.0 to 1.8 according to Equation 1 described in the present specification.

**EP 4 787 487 A1**

**(Cont. next page)**

[FIG. 1]

**Description**

**TECHNICAL FIELD**

**Cross-reference to Related Applications**

This application claims the benefit of Korean Patent Application No. 10-2023-0151125, filed on November 3, 2023, in the Korean Intellectual Property Office, the disclosure of which is incorporated herein in its entirety by reference.

**Technical Field**

The present invention relates to a positive electrode active material, a preparation method thereof, and a positive electrode and a lithium secondary battery including the positive electrode active material, and more specifically, to a positive electrode active material having a uniform particle diameter, a preparation method thereof, and a positive electrode and a lithium secondary battery including the positive electrode active material.

**BACKGROUND ART**

In recent years, as the technology development and demand for mobile devices and electric vehicles have increased, the demand for secondary batteries as an energy source has been rapidly increased. Among such secondary batteries, lithium secondary batteries having high energy density and voltage, long cycle life, and low self-discharging rate have been commercialized and widely used.

As a positive electrode active material for a lithium secondary battery, lithium transition metal oxides such as a lithium cobalt oxide such as $LiCoO_2$, a lithium nickel oxide such as $LiNiO_2$, a lithium manganese oxide such as $LiMnO_2$ or $LiMn_2O_4$, a lithium iron phosphate oxide such as $LiFePO_4$, and the like have been developed, and in recent years, a lithium composite transition metal oxide including two or more types of transition metals such as $Li[Ni_aCo_bMn_c]O_2$, $Li[Ni_aCo_bAl_c]O_2$, and $Li[Ni_aCo_bMn_cAl_d]O_2$ has been developed and widely used.

Meanwhile, the lithium composite transition metal oxide has a problem of having poor lifespan properties at high temperatures, and when the lithium composite transition metal oxide is used as a positive electrode active material when manufacturing a lithium secondary battery, during a process in which the positive electrode active material is applied on a positive electrode current collector and then roll-pressed, particles of the positive electrode active material are easily cracked and collapsed. Accordingly, during charging and discharging of the lithium secondary battery, gas is generated due to a side reaction between the positive electrode active material and an electrolyte solution, and a swelling phenomenon occurs, so that there is a problem in that lifespan properties are deteriorated.

Therefore, there is a need for the development of a positive electrode active material capable of improving stability and lifespan properties of a battery.

**DISCLOSURE OF THE INVENTION**

**TECHNICAL PROBLEM**

In order to solve the above-described problem, an object of the present invention is to provide a positive electrode active material including a lithium composite transition metal oxide capable of improving stability and lifespan properties of a battery.

In addition, another object of the present invention is to provide a preparation method for preparing the positive electrode active material.

In addition, another object of the present invention is to provide a lithium secondary battery having improved performance by including the above-described positive electrode active material.

**TECHNICAL SOLUTION**

In order to achieve the above-described objects, the present invention provides a positive electrode active material, a preparation method of the positive electrode active material, a positive electrode, and a lithium secondary battery.

(1) The present invention provides a positive electrode active material including a lithium nickel cobalt manganese-based oxide having a nickel content of 50 mol% or greater among all transition metals, and in the form of a single particle composed of 10 or fewer primary particles, wherein the positive electrode active material has a polydispersity index (PDI) value of 1 to 1.8 according to Equation 1 below:

PDI = Volume average particle diameter ($\mu$m) of primary particles /Number-average particle diameter ($\mu$m) of primary particles [Equation 1]

(2) In (1) above, the present invention provides a positive electrode active material, wherein the lithium nickel cobalt manganese-based oxide has a composition represented by Formula 1 below.

[Formula 1] $Li_{1+x}Ni_{a1}Co_{b1}Mn_{c1}M^1_{d1}O_2$

wherein in Formula 1 above, $M^1$ is one or more selected from Al, W, Co, B, Zr, Y, Ce, Hf, La, Ba, F, P, S, Nb, Ta, Sc, Cr, V, Cu, Sr, Ti, Mg, Mo, Sn, Fe, Zn, and Si, and $-0.1 \leq x \leq 0.1$, $0.5 \leq a1 < 1$, $0 < b1 < 0.5$, $0 < c1 < 0.5$, $0 \leq d1 \leq 0.2$, and $a1+b1+c1+d1=1$.

(3) In (1) or (2) above, the present invention provides a positive electrode active material, wherein the primary particles have a volume average particle diameter of 0.5 $\mu$m to 3.5 $\mu$m.

(4) In any one of (1) to (3) above, the present invention provides a positive electrode active material, wherein the primary particles have a number-average particle diameter of 0.5 $\mu$m to 2.0 $\mu$m.

(5) In any one of (1) to (4) above, the present invention provides a positive electrode active material, wherein the positive electrode active material has a $D_{50}$ of 3 $\mu$m to 5 $\mu$m as measured by using a particle size analyzer (PSA).

(6) In any one of (1) to (5) above, the present invention provides a positive electrode active material, wherein a ratio of the number of particles having a particle diameter of less than 1 $\mu$m as measured by a PSA particle (particle size analyzer) with respect to the total number of particles after placing 3 g of the positive electrode active material in a mold having an inner diameter of 13 mm, and then pressing the same at 9 tons for 1 minute is 2.5% or less.

(7) The present invention provides a method for preparing a positive electrode active material, wherein the method includes (A) mixing a nickel cobalt manganese-based hydroxide having a nickel content of 50 mol% or greater among all transition metals and a lithium-containing raw material, thereby preparing a mixture, and (B) under an atmospheric atmosphere, subjecting the mixture to primary firing at 600 °C to 900 °C, continuously heating the mixture to 920 °C to 1000 °C, and then subjecting the mixture to secondary firing at 920 °C to 1000 °C, thereby preparing a fired product.

(8) In (7) above, the present invention provides a method for preparing a positive electrode active material, wherein the nickel cobalt manganese-based hydroxide has a composition represented by Formula 2 below.

[Formula 2] $Ni_{a2}Co_{b2}Mn_{c2}M^2_2(OH)_2$

In Formula 2 above, $M^2$ is one or more selected from Al, W, Co, B, Zr, Y, Ce, Hf, La, Ba, F, P, S, Nb, Ta, Sc, Cr, V, Cu, Sr, Ti, Mg, Mo, Sn, Fe, Zn, and Si, and $0.5 \leq a2 < 1$, $0 < b2 < 0.5$, $0 < c2 < 0.5$, $0 \leq d2 \leq 0.2$, and $a2+b2+c2+d2=1$.

(9) In (7) or (8) above, the present invention provides a method for preparing a positive electrode active material, wherein the secondary firing is performed for 1 hours to 12 hours.

(10) In (7) to (9) above, the present invention provides a method for preparing a positive electrode active material, wherein the secondary firing is performed for 4 hours to 14 hours.

(11) In any one of (7) to (10) above, the present invention provides a method for preparing a positive electrode active material, wherein the method further includes (C) finely pulverizing the fired product.

(12) In (11) above, the present invention provides a method for preparing a positive electrode active material, wherein the fine pulverization is performed by vortex flow-type pulverization.

(13) In (12) above, the present invention provides a method for preparing a positive electrode active material, wherein the vortex flow-type pulverization is performed under a pressure of 1 bar to 5 bar.

(14) The present invention provides a positive electrode including the positive electrode active material according to any one of (1) to (6) above.

(15) The present invention provides a lithium secondary battery including the above positive electrode according to (14) above, a negative electrode, a separator interposed between the positive electrode and the negative electrode, and an electrolyte.

## ADVANTAGEOUS EFFECTS

A positive electrode active material of the present invention includes a lithium composite transition metal oxide, and has a polydispersity index value satisfying a specific range according to Equation 1 described in the present specification, thereby having a uniform particle diameter, so that particle breakage may be reduced, and lifespan performance of a lithium secondary battery may be improved.

In addition, according to a method for preparing a positive electrode active material of the present invention, the above-described positive electrode active material may be effectively prepared. Specifically, in the method for preparing a positive electrode active material according to the present invention, a mixture including a positive electrode active material precursor and a lithium-containing raw material is subjected to primary firing at 600 °C to 900 °C, continuously heated to 920 °C to 1000 °C, and then subjected to secondary firing at 920 °C to 1000 °C, so that the particle diameter uniformity of primary particles may be improved.

A positive electrode and a lithium secondary battery according to the present invention may be excellent in high-temperature stability and lifespan performance.

## BRIEF DESCRIPTION OF THE DRAWINGS

FIG. 1 is a diagram showing a firing profile according to an embodiment of the present invention.
FIG. 2 is an SEM image of a positive electrode active material of Example 1.
FIG. 3 is an SEM image of a positive electrode active material of Example 2.
FIG. 4 is an SEM image of a positive electrode active material of Comparative Example 1.
FIG. 5 is an SEM image of a positive electrode active material of Comparative Example 2.

## BEST MODE FOR CARRYING OUT THE INVENTION

Hereinafter, the present invention will be described in more detail to facilitate understanding of the present invention.

It will be understood that terms or words used in the present specification and claims shall not be construed as being limited to having meanings defined in commonly used dictionaries, but should be interpreted as having meanings and concepts consistent with the technical idea of the present invention based on the principle that an inventor may appropriately define concepts of the terms to best explain the invention.

In the present specification, it should be understood that the term 'include,' 'comprise,' or 'have' is intended to specify the presence of stated features, numbers, steps, elements, or combinations thereof, but do not preclude the presence or addition of one or more other features, numbers, steps, elements, or combinations thereof.

In the present specification, the term 'on' includes not only a case in which a certain component is formed directly on an upper surface of another component, but also a case in which a third component is interposed therebetween.

In the present specification, a 'single particle form' is a concept in contrast to a spherical secondary particle form which is formed by the aggregation of tens to hundreds of primary particles manufactured by a typical method, and means a form composed of 10 or fewer primary particles. Specifically, in the present invention, the single particle form may refer to a single particle composed of one primary particle, or may refer to a secondary particle form in which several primary particles are aggregated.

The 'primary particle' means the minimum unit of particles recognized when observing a positive electrode active material through a scanning electron microscope, and the 'secondary particle' means a secondary structural body formed by the aggregation of a plurality of primary particles.

In the present specification, a 'volume average particle diameter of primary particles' is a value according to Equation 2 below, and is a value derived by calculating the area of each of the primary particles through the number of pixels corresponding to each of n primary particles present in an SEM image, using a radius ($r_i$) of a circle having the same area as the area of each of the primary particles, thereby calculating a particle diameter ($D_i=2r_i$) and a volume ($V_i=4/3\times\pi r_i^3$) of each of the primary particles present in the SEM image, and dividing the total sum of values ($V_iD_i$), which is obtained by multiplying the volume and the particle diameter calculated for each primary particle, by the total sum of the volumes ($V_i$) calculated.

[Equation 2]

$$\text{Volume average particle diameter of primary particles}$$

$$= \frac{\sum_{i=1}^{n} V_i D_i}{\sum_{i=1}^{n} V_i}$$

In Equation 2 above, n is the number of primary particles present in an SEM image, $V_i$ is the volume of one primary particle among n primary particles, and $V_iD_i$ is a value obtained by multiplying the volume ($V_i$) and the particle diameter ($D_i$)

of one primary particle among n primary particles.

In the present specification, a 'number-average particle diameter of primary particles' is a value derived by calculating the area of each of the primary particles through the number of pixels corresponding to each of n primary particles present in an SEM image, using a radius ($r_i$) of a circle having the same area as the area of each of the primary particles, thereby calculating a particle diameter ($D_i = 2r_i$) of each of the primary particles present in the SEM image, and dividing the total sum of the calculated particle diameters by the number of the primary particles.

$$[\text{Equation 3}]$$

$$\text{Number-average particle diameter of primary particles}$$

$$= \frac{\sum_{i=1}^{n} D_i}{n}$$

In Equation 3 above, n is the number of primary particles present in an SEM image, and $D_i$ is a particle diameter ($D_i$) of one primary particle among n primary particles.

In the present specification, the term '$D_{50}$ as measured by using a particle size analyzer (PSA)' means a particle diameter at a point of 50% in a volume cumulative distribution according to a particle diameter. The $D_{50}$ may be measured by dispersing powder to be measured in a dispersion medium, and then introducing the mixture into a commercially available laser diffraction particle size measurement device (for example, S3500 of Microtrac Co., Ltd.) to calculate a particle size distribution by measuring the difference in diffraction pattern according to a particle size when particles pass through a laser beam, and then calculating the particle diameter at a point of 50% in a volume cumulative distribution according to a particle diameter in the measurement device.

**Positive electrode active material**

The present invention provides a positive electrode active material including a lithium nickel cobalt manganese-based oxide (lithium composite transition metal oxide) having a nickel content of 50 mol% or greater among all transition metals, and in the form of a single particle composed of 10 or fewer primary particles, wherein the positive electrode active material has a polydispersity index (PDI) value of 1 to 1.8 according to Equation 1 below. The lithium nickel cobalt manganese-based oxide may have a layered structure.

PDI = Volume average particle diameter ($\mu$m) of primary particles /Number-average particle diameter ($\mu$m) of primary particles [Equation 1]

The present inventors have found that if a positive electrode active material includes the above-described lithium nickel cobalt manganese-based oxide in the form of a single particle, and has a polydispersity index (PDI) value satisfying a specific range according to Equation 1 above, the particle diameter of primary particles is uniform, so that there is a small number of fine particles, and there is reduced breakage of particles during a fine pulverization process and a roll-pressing process for the manufacture of a lithium secondary battery, so that lifespan performance of the lithium secondary battery is improved, and have completed the present invention.

According to the present invention, the positive electrode active material has a polydispersity index (PDI) value of 1.0 to 1.8 according to Equation 1. Theoretically, if all primary particles constituting the lithium nickel cobalt manganese-based oxide have the same particle diameter, a polydispersity index (PDI) value is 1.0, and the more uniform the particle diameter, the closer the value is to 1.0. The polydispersity index value may specifically be 1.0 or greater, 1.1 or greater, 1.2 or greater, 1.3 or greater, 1.4 or greater, 1.5 or greater, or 1.6 or greater, and 1.7 or less, or 1.8 or less. If the polydispersity index value satisfies the above-described range, the uniformity of primary particles may be improved and particle breakage may be reduced. The polydispersity index value is determined by a combination of the preparation method and composition of a positive electrode active material, the size and particle size distribution of primary particles, and the like, and is not determined by any one factor.

Meanwhile, if the polydispersity index value of the positive electrode active material is greater than 1.8, the primary particle size is not uniform, fine particles increase, and particle breakage increases during a fine pulverization process and a roll-pressing process for the manufacture of a lithium secondary battery, so that there is a problem in that lifespan performance of a lithium secondary battery is degraded.

According to the present invention, the primary particles may have a volume average particle diameter of 0.5 $\mu$m to 3.5 $\mu$m. The volume average particle diameter of the primary particles may specifically be 0.5 $\mu$m or greater, 0.6 $\mu$m or

greater, 0.7 μm or greater, 0.8 μm or greater, 0.9 μm or greater, 1.0 μm or greater, 1.1 μm or greater, 1.2 μm or greater, 1.3 μm or greater, 1.4 μm or greater, 1.5 μm or greater, 1.6 μm or greater, 1.7 μm or greater, 1.8 μm or greater, 1.9 μm or greater, 2.0 μm or greater, 2.1 μm or greater, 2.2 μm or greater, or 2.3 μm or greater, and 2.6 μm or less, 2.7 μm or less, 2.8 μm or less, 2.9 μm or less, or 3.0 μm or less. If the volume average particle diameter of primary particles is within the above-described range, a positive electrode active material may have a single particle form, and since it is advantageous in moving lithium, both the lifespan and capacity properties of a battery may be improved, so that the electrochemical performance may be optimized.

According to the present invention, the primary particles may have a number average particle diameter of 0.5 μm to 2.0 μm. The number average particle diameter of the primary particles may specifically be 0.5 μm or greater, 0.6 μm or greater, 0.7 μm or greater, 0.8 μm or greater, 0.9 μm or greater, 1.0 μm or greater, 1.1 μm or greater, 1.2 μm or greater, or 1.3 μm or greater, and 1.6 μm or less, 1.7 μm or less, 1.8 μm or less, 1.9 μm or less, or 2.0 μm or less. If the number average particle diameter of primary particles is within the above-described range, a positive electrode active material may have a single particle form, and both the lifespan and capacity properties of a battery may be improved, so that the electrochemical performance may be optimized.

According to the present invention, the lithium nickel cobalt manganese-based oxide may have a nickel content of 50 mol% or greater, 51 mol% or greater, 52 mol% or greater, 53 mol% or greater, 54 mol% or greater, 55 mol% or greater, 56 mol% or greater, 57 mol% or greater, 58 mol% or greater, 59 mol% or greater, or 60 mol% or greater among all transition metals. That is, the lithium nickel cobalt manganese-based oxide may be a lithium composite transition metal oxide having a high nickel content. In this case, the energy density of a lithium secondary battery may be improved.

According to the present invention, the lithium nickel cobalt manganese-based oxide may have a composition represented by Formula 1 below.

$$[\text{Formula 1}] \qquad Li_{1+x}Ni_{a1}Co_{b1}Mn_{c1}M^1_{d1}O_2$$

In Formula 1 above, $M^1$ is one or more selected from Al, W, Co, B, Zr, Y, Ce, Hf, La, Ba, F, P, S, Nb, Ta, Sc, Cr, V, Cu, Sr, Ti, Mg, Mo, Sn, Fe, Zn, and Si, and $-0.1 \leq x \leq 0.1$, $0.5 \leq a1 < 1$, $0 < b1 < 0.5$, $0 < c1 < 0.5$, $0 \leq d1 \leq 0.2$, and $a1+b1+c1+d1=1$.

The x above may be -0.1 or greater, -0.09 or greater, -0.08 or greater, -0.07 or greater, -0.06 or greater, -0.05 or greater, -0.04 or greater, -0.03 or greater, -0.02 or greater, -0.01 or greater, 0 or greater, 0.01 or greater, 0.02 or greater, 0.03 or greater, 0.04 or greater, or 0.5 or greater, and 0.07 or less, 0.08 or less, 0.09 or less, or 0.1 or less. When the x satisfies the above-described range, high-capacity properties and a high energy density per unit volume may be implemented.

According to the present invention, in Formula 1 above, the a1 represents the molar ratio of nickel among metal elements in the lithium nickel cobalt manganese-based oxide, and may be 0.50 or greater, 0.51 or greater, 0.52 or greater, 0.53 or greater, 0.54 or greater, 0.55 or greater, 0.56 or greater, 0.57 or greater, 0.58 or greater, 0.59 or greater, or 0.60 or greater, and 0.70 or less, 0.75 or less, 0.80 or less, 0.85 or less, 0.90 or less, 0.95 or less, or less than 1.0. If the a1 satisfies the above-described range, high-energy properties may be implemented, and particularly, if the a1 is 0.6 to 0.7, a high energy density and high stability may be implemented during high-voltage driving.

According to the present invention, in Formula 1 above, the b1 represents the atomic molar ratio of cobalt among metal elements in the lithium nickel cobalt manganese-based oxide, and may be greater than 0.0, or 0.01 or greater, and 0.15 or less, 0.20 or less, 0.30 or less, 0.40 or less, or less than 0.50. If the b1 satisfies the above-described range, stability may be improved during charging and discharging, and rate properties may be improved.

According to the present invention, in Formula 1 above, the c1 represents the molar ratio of manganese among metal elements in the lithium nickel cobalt manganese-based oxide, and may be greater than 0.0, or 0.01 or greater, 0.05 or greater, 0.10 or greater, 0.15 or greater, 0.20 or greater, 0.25 or greater, or 0.30 or greater, and 0.35 or less, 0.40 or less, 0.45 or less, or less than 0.50. If the c1 satisfies the above-described range, high-temperature stability may increase and a side reaction with an electrolyte solution may relatively decrease.

According to the present invention, in Formula 1 above, the d1 represents the molar ratio of an $M^1$ element among metal elements in the lithium nickel cobalt manganese-based oxide, and may be 0.0 or greater, and 0.05 or less, 0.1 or less, or 0.2 or less. When the d1 satisfies the above-described range, the crystal structure stability of a positive electrode active material may be improved, and the particle shape may be improved.

According to the present invention, the $M^1$, which is one or more selected from Al, W, Co, B, Zr, Y, Ce, Hf, La, Ba, F, P, S, Nb, Ta, Sc, Cr, V, Cu, Sr, Ti, Mg, Mo, Sn, Fe, Zn, and Si, is a doping element capable of improving the crystallinity and single-particleization of a positive electrode active material, and is not necessarily included, but if the $M^1$ is included, capacity properties and lifespan properties of a battery may be improved.

According to the present invention, the positive electrode active material may have a $D_{50}$ of 3 μm to 5 μm as measured by using a particle size analyzer (PSA). The $D_{50}$ of the positive electrode active material may specifically be 3.00 μm or greater, 3.10 μm or greater, 3.20 μm or greater, 3.30 μm or greater, 3.40 μm or greater, or 3.50 μm or greater, and 4.50 μm or less, 4.60 μm or less, 4.70 μm or less, 4.80 μm or less, 4.90 μm or less, or 5.00 μm or less. If the $D_{50}$ of a positive

electrode active material as measured by using a particle size analyzer (PSA) is within the above-described range, both the lifespan and capacity properties of a battery including the positive electrode active material may be improved, so that the electrochemical performance may be optimized. For reference, if the $D_{50}$ is less than 3 $\mu$m, the lifespan of the battery may be reduced, and if the $D_{50}$ is greater than 5 $\mu$m, the capacity of the battery may be reduced.

According to the present invention, a ratio of the number of particles having a particle diameter of less than 1 $\mu$m as measured by a particle size analyzer (PSA) with respect to the total number of particles after placing 3 g of the positive electrode active material in a mold having an inner diameter of 13 mm, and then pressing the same at 9 tons for 1 minute may be 2.5% or less, 2.0% or less, 1.5% or less, 1.4% or less, 1.3% or less, or 1.2% or less. In this case, the breakage of the positive electrode active material particles may be reduced during roll-pressing for the manufacture of a lithium secondary battery, so that the lifespan of the lithium secondary battery may be improved.

**Method for preparing positive electrode active material**

The present invention provides a method for preparing the above-described positive electrode active material. That is, the positive electrode active material according to the present invention is prepared by the following method for preparing a positive electrode active material.

The method for preparing a positive electrode active material according to the present invention includes (A) mixing a nickel cobalt manganese-based hydroxide having a nickel content of 50 mol% or greater among all transition metals and a lithium-containing raw material, thereby preparing a mixture, and (B) under an atmospheric atmosphere, subjecting the mixture to primary firing at 600 °C to 900 °C, continuously heating the mixture to 920 °C to 1000 °C, and then subjecting the mixture to secondary firing at 920 °C to 1000 °C, thereby preparing a fired product.

The present inventors have found that if the mixture is subjected to primary firing at 600 °C to 900 °C, continuously heated to 920 °C to 1000 °C, and then subjected to secondary firing at 920 °C to 1000 °C, a lithium nickel cobalt manganese-based oxide in the form of a single particle having a uniform particle diameter of primary particles is prepared, so that the breakage of positive electrode active material particles is reduced during roll-pressing for the manufacture of a lithium secondary battery, and have completed the present invention.

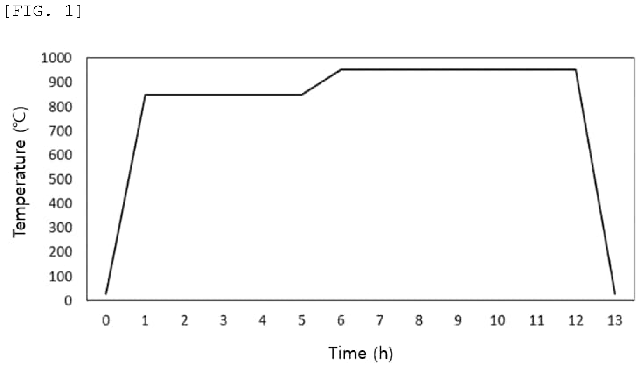

For example, the positive electrode active material according to the present invention may be prepared by heating the mixture to 850 °C from room temperature as shown in FIG. 1, subjecting the mixture to primary firing at 850 °C for a predetermined period of time, continuously heating the mixture to 950 °C, and then subjecting the mixture to secondary firing at 950°C for a predetermined period of time. FIG. 1 is a diagram showing a firing profile according to an embodiment of the present invention.

**Step (A)**

Step (A) above is a step of mixing a nickel cobalt manganese-based hydroxide (hereinafter, a composite transition metal hydroxide or positive electrode active material precurs or) having a nickel content of 50 mol% or greater among all transition metals and a lithium-containing raw material, thereby preparing a mixture.

According to the present invention, the nickel cobalt manganese-based hydroxide may have a composition represented by Formula 2 below.

[Formula 2] $\qquad Ni_{a2}Co_{b2}Mn_{c2}M^2_{d2}(OH)_2$

In Formula 2 above, $M^2$ is one or more selected from Al, W, Co, B, Zr, Y, Ce, Hf, La, Ba, F, P, S, Nb, Ta, Sc, Cr, V, Cu, Sr, Ti, Mg, Mo, Sn, Fe, Zn, and Si, and $0.5 \leq a2 < 1$, $0 < b2 < 0.5$, $0 < c2 < 0.5$, $0 \leq d2 \leq 0.2$, and $a2+b2+c2+d2=1$.

According to the present invention, in Formula 2 above, the a2 represents the molar ratio of nickel among metal elements in the nickel cobalt manganese-based hydroxide, and may be 0.50 or greater, 0.51 or greater, 0.52 or greater, 0.53 or greater, 0.54 or greater, 0.55 or greater, 0.56 or greater, 0.57 or greater, 0.58 or greater, 0.59 or greater, or 0.60 or greater, and 0.70 or less, 0.75 or less, 0.80 or less, 0.85 or less, 0.90 or less, 0.95 or less, or less than 1.0. If the a2 satisfies the above-described range, high-capacity properties of a battery including a positive electrode active material to be prepared as a result may be implemented, and particularly, if the a2 is 0.6 to 0.7, a battery including a positive electrode active material to be prepared as a result may exhibit a high energy density during high-voltage driving, so that high-capacity properties may be implemented.

According to the present invention, in Formula 2 above, the b2 represents the atomic molar ratio of cobalt among metal elements in the nickel cobalt manganese-based hydroxide, and may be greater than 0.0, or 0.01 or greater, and 0.15 or less, 0.20 or less, 0.30 or less, 0.40 or less, or less than 0.50. If the b2 satisfies the above-described range, stability in a process of charging and discharging a battery including a positive electrode active material to be prepared as a result may be improved, and rate properties may be improved.

According to the present invention, in Formula 2 above, the c2 represents the molar ratio of manganese among metal elements in the nickel cobalt manganese-based hydroxide, and may be greater than 0.0, or 0.01 or greater, 0.05 or greater, 0.10 or greater, 0.15 or greater, 0.20 or greater, 0.25 or greater, or 0.30 or greater, and 0.35 or less, 0.40 or less, 0.45 or less, or less than 0.50. If the c2 satisfies the above-described range, high-capacity properties of a battery including a positive electrode active material to be prepared as a result may be implemented. In addition, high-temperature stability of the battery may increase, and a side reaction with an electrolyte solution may relatively decrease.

According to the present invention, in Formula 2 above, the d2 represents the molar ratio of an $M^1$ element among metal elements in the nickel cobalt manganese-based hydroxide, and may be 0.0 or greater, and 0.05 or less, 0.1 or less, or 0.2 or less. If the d2 satisfies the above-described range, the crystal structure stability of a positive electrode active material to be prepared as a result may be improved, and the particle shape may be improved.

According to the present invention, the lithium-containing raw material may be a sulfate, a nitrate, an acetate, a carbonate, an oxalate, a citrate, a halide, a hydroxide, an oxyhydroxide, or the like, which contains lithium, and is not particularly limited as long as it can be dissolved in water. Specifically, the lithium-containing raw material may be $Li_2CO_3$, $LiNO_3$, $LiNO_2$, LiOH, $LiOH·H_2O$, LiH, LiF, LiCl, LiBr, LiI, $CH_3COOLi$, $Li_2O$, acetic acid lithium, dicarboxylic acid lithium, citric acid lithium, fatty acid lithium, alkyllithium, lithium halide, or the like, and any one thereof or a mixture of two or more thereof may be used.

According to the present invention, the composite transition metal hydroxide and the lithium-containing raw material may be mixed such that a ratio (M:Li) of the total number of moles (M) of transition metals included in the composite transition metal hydroxide to the number of moles of lithium (Li) included in the lithium-containing raw material is to be 1:1.0 to 1.1, 1:1.01 to 1.09, 1:1.02 to 1.08, 1:1.03 to 1.07, 1:1.04 to 1.07, or 1:1.05 to 1.07.

Meanwhile, during the mixing of Step (A), a doping element-containing raw material may be further mixed. The doping element-containing raw materials may serve as a flux during firing, and thus, may further improve the lifespan and resistance properties of a battery including the positive electrode active material.

**Step (B)**

Step (B) above is a step of, under an atmospheric atmosphere, subjecting the mixture to primary firing at 600 °C to 900 °C, continuously heating the mixture to 920 °C to 1000 °C, and then subjecting the mixture to secondary firing at 920 °C to 1000 °C, thereby preparing a fired product.

According to the present invention, when the mixture is subjected to primary firing at 600 °C to 900 °C, the lithium-containing raw material is dissolved and sufficiently uniformly distributed on the surface of the positive electrode active material precursor, and as a result, lithium and the positive electrode active material precursor effectively react, so that an active material having an uniform primary particle shape may be finally prepared after the secondary firing. The primary firing temperature may specifically be 600 °C or higher, 610 °C or higher, 620 °C or higher, 630 °C or higher, 640 °C or higher, 650 °C or higher, 660 °C or higher, 670 °C or higher, 680 °C or higher, 690 °C or higher, 700 °C or higher, 710 °C or higher, 720 °C or higher, 730 °C or higher, 740 °C or higher, 750 °C or higher, 760 °C or higher, 770 °C or higher, 780 °C or higher, 790 °C or higher, 800 °C or higher, 810 °C or higher, 820 °C or higher, or 830 °C or higher, and 870 °C or lower, 880 °C or lower, 890 °C or lower, or 900 °C or lower. If the primary firing temperature is within the above-described range, the uniformity of primary particles may increase. Meanwhile, if the primary firing temperature is lower than 600 °C, the reaction between the lithium and the positive electrode active material precursor does not progress sufficiently, thereby forming a positive electrode active material in the form of a secondary particle in which more than 10 primary particles are aggregated during the secondary firing, so that there is a problem in that lifespan properties are degraded, and if higher than 900 °C, the growth of primary particles progresses rapidly, thereby inducing the growth of non-uniform particles during the secondary firing, so that there is a problem in that the capacity is reduced.

According to the present invention, the primary firing may be performed under an oxygen atmosphere or an atmospheric atmosphere.

According to the present invention, the primary firing may be performed for 2 hours to 12 hours. In this case, a reaction between the nickel cobalt manganese-based hydroxide and lithium progresses adequately, so that the uniform distribution of lithium may be achieved even to the inside of a positive electrode active material, and the uniform particle growth may be achieved overall.

Immediately after the primary firing is completed, if the temperature is continuously raised to 920 °C to 1000 °C, and the secondary firing is performed at 920 °C to 1000 °C, lithium is intercalated into the positive electrode active material precursor, thereby forming a layered structure, and interfaces of primary particles are combined with each other to achieve the growth of the primary particles, and a fired product is prepared. In this case, the fired product is a lithium nickel cobalt manganese-based oxide having a nickel content of 50 mol% or greater among all transition metals, and in the form of a single particle composed of 10 or fewer primary particles. If the secondary firing temperature is within the above-described range, primary particles are grown to a sufficient size, and structural stability increases, so that thermal stability and lifespan properties may be improved. Meanwhile, if the secondary firing temperature is lower than 920 °C, the size of primary particles is small, thereby preparing a non-uniform positive electrode active material in the form of a secondary particle, not in the form of a single particle, so that there is a problem in that lifespan is reduced, and if higher than 1000 °C, the size of primary particles becomes too large, so that the capacity and performance of a battery may be degraded.

The secondary firing may be performed under a lithium transition metal oxygen atmosphere or an atmospheric atmosphere.

According to the present invention, the secondary firing may be performed for 4 hours to 14 hours. In this case, primary particles having high crystallinity and an adequate size may be obtained, and the production efficiency may be excellent.

The present invention divides a firing process into primary firing and secondary firing, wherein the primary firing temperature is lower than the secondary firing temperature, which may increase the particle uniformity of a positive electrode active material, and may finally improve the lifespan of a battery including the positive electrode active material.

The method for preparing a positive electrode active material according to the present invention may further include (C) finely pulverizing the fired product, in terms of crushing large particles aggregated together by weak force during the firing process, thereby forming a single particle form.

According to the present invention, the fine pulverization may be performed by vortex flow-type pulverization. In this case, through the collision of particles in the positive electrode active material, the particles aggregated in the firing process may be crushed, which may increase uniformity during loading of the positive electrode active material when manufacturing an electrode.

According to the present invention, the vortex flow-type pulverization may be performed under a pressure of 1 bar to 5 bar. In this case, it is possible to reduce the amount of fine particles which may be generated due to the collision of the particles during the fine pulverization process.

**Positive electrode**

The present invention provides a positive electrode including the above-described positive electrode active material.

The positive electrode may include a positive electrode current collector, and a positive electrode active material layer formed on the positive electrode current collector, and the positive electrode active material layer may include the above-described positive electrode active material.

The positive electrode current collector may include a highly conductive metal, and is not particularly limited as long as it is not reactive in a voltage range of a battery while a positive electrode active material layer is able to be easily adhered to the positive electrode current collector. As the positive electrode current collector, for example, stainless steel, aluminum, nickel, titanium, fired carbon, or aluminum or stainless steel that is surface-treated with one of carbon, nickel, titanium, silver, and the like may be used. In addition, the positive electrode current collector may typically have a thickness of 3 $\mu$m to 500 $\mu$m, and microscopic irregularities may be formed on the surface of the current collector to improve the adhesion of the positive electrode active material. For example, the positive electrode current collector may be used in various forms such as a film, a sheet, a foil, a net, a porous body, a foam, and a non-woven body.

The positive electrode active material layer may selectively include, if necessary, a conductive material and a binder together with the positive electrode active material. In this case, the positive electrode active material may be included in a content of 80 wt% to 99 wt%, more specifically, 85 wt% to 98.5 wt% with respect to the total weight of the positive electrode active material layer, and may exhibit excellent capacity performance within the above-described ranges.

The conductive material is used to impart conductivity to an electrode, and any conductive material may be used without particular limitation as long as it has electron conductivity without causing a chemical change in a battery to be constituted. Specific examples thereof may include graphite such as natural graphite or artificial graphite; a carbon-based material such as carbon black, acetylene black, Ketjen black, channel black, furnace black, lamp black, thermal black, and carbon fiber; metal powder or metal fiber of such as copper, nickel, aluminum, and silver; a conductive tube such as a carbon nanotube; a conductive whisker such as a zinc oxide whisker and a potassium titanate whisker; a conductive metal oxide such as a titanium oxide; or a conductive polymer such as a polyphenylene derivative, and any one thereof or a mixture of two or more thereof may be used. The conductive material may be included in an amount of 0.1 wt% to 15 wt% with respect to the total weight of the positive electrode active material layer.

The binder serves to improve the bonding between positive electrode active material particles and the adhesive force between the positive electrode active material and the current collector. Specific examples thereof may include polyvinylidene fluoride (PVDF), a polyvinylidene fluoride-hexafluoropropylene copolymer (PVDF-co-HFP), polyvinyl alcohol, polyacrylonitrile, polymethymethaxrylate, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene monomer (EPDM), a sulfonated EPDM, styrene-butadiene rubber (SBR), fluorine rubber, a poly acrylic acid, a polymer having the hydrogen thereof substituted with Li, Na, or Ca, or various copolymers thereof, and any one thereof or a mixture of two or more thereof may be used. The binder may be included in an amount of 0.1 wt% to 15 wt% with respect to the total weight of the positive electrode active material layer.

The positive electrode may be manufactured according to a typical method for manufacturing a positive electrode except that the positive electrode active material described above is used. Specifically, the positive electrode may be manufactured by applying a composition for forming a positive electrode active material layer, which is prepared by dissolving or dispersing the above-described positive electrode active material, and selectively, if necessary, a binder, a conductive material, and a dispersant in a solvent, on a positive electrode current collector, followed by drying and roll-pressing, or manufactured by casting the composition for forming a positive electrode active material layer on a separate support, and then laminating a film obtained by peeling the same off from the support on the positive electrode current collector.

The solvent may be a solvent commonly used in the art, and may be dimethyl sulfoxide (DMSO), isopropyl alcohol, N-methylpyrrolidone (NMP), dimethyl formamide (DMF), acetone, water, or the like, and any one thereof or a mixture of two or more thereof may be used. The amount of the solvent to be used is sufficient if the solvent dissolves or disperses the positive electrode active material, the conductive material, the binder, and the dispersant in consideration of the coating thickness of a slurry, and a manufacturing yield, and thereafter, allows the slurry to have a viscosity capable of exhibiting excellent thickness uniformity when applied for manufacturing the positive electrode.

## Lithium secondary battery

The present invention provides a lithium secondary battery including the above-described positive electrode, a negative electrode, a separator interposed between the positive electrode and the negative electrode, and an electrolyte.

The lithium secondary battery may selectively further include a battery case for accommodating an electrode assembly of the positive electrode, the negative electrode, and the separator, and a sealing member for sealing the battery case.

The negative electrode may include a negative electrode current collector, and a negative electrode active material layer positioned on the negative electrode current collector.

The negative electrode current collector is not particularly limited as long as it has high conductivity without causing a chemical change in a battery, and for example, copper, stainless steel, aluminum, nickel, titanium, fired carbon, copper or stainless steel that is surface-treated with one of carbon, nickel, titanium, silver, and the like, an aluminum-cadmium alloy, and the like may be used. Also, the negative electrode current collector may typically have a thickness of 3 $\mu$m to 500 $\mu$m, and as in the case of the positive electrode current collector, microscopic irregularities may be formed on the surface of the negative electrode current collector to improve the binding force of the negative electrode active material. For example, the negative electrode current collector may be used in various forms such as a film, a sheet, a foil, a net, a porous body, a foam, and a non-woven body.

The negative electrode active material layer may selectively include a binder and a conductive material together with the negative electrode active material.

As the negative electrode active material, a compound capable of reversible intercalation and de-intercalation of lithium may be used. Specific examples thereof may include a carbonaceous material such as artificial graphite, natural graphite, graphitized carbon fiber, and amorphous carbon; a metallic compound alloyable with lithium such as Si, Al, Sn, Pb, Zn, Bi, In, Mg, Ga, Cd, an Si alloy, an Sn alloy, or an Al alloy; a metal oxide which may be doped and undoped with lithium such as $SiO_\beta$ ($0 < \beta < 2$), $SnO_2$, a vanadium oxide, and a lithium vanadium oxide; or a composite including the metallic compound and the carbonaceous material such as an Si-C composite or an Sn-C composite, and any one thereof or a mixture of two or more thereof may be used. In addition, a metal lithium thin film may be used as the negative electrode active material. In addition, low crystalline carbon, high crystalline carbon, and the like may all be used as a carbon material. Representative examples of the low crystalline carbon may include soft carbon and hard carbon, and representative examples of the high crystalline carbon may include irregular, planar, flaky, spherical, or fibrous natural graphite or artificial graphite, Kish graphite, pyrolytic carbon, mesophase pitch-based carbon fiber, meso-carbon microbeads, mesophase pitches, and high-temperature fired carbon such as petroleum or coal tar pitch derived cokes. The negative electrode active material may be included in 80 wt% to 99 wt% based on the total weight of the negative electrode active material layer.

The binder of the negative electrode active material layer is a component for assisting in bonding between a conductive material, an active material, and a current collector, and is typically added in an amount of 0.1 wt% to 10 wt% based on the total weight of a negative electrode active material layer. Examples of the binder may include polyvinylidene fluoride (PVDF), polyvinyl alcohol, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene monomer (EPDM), a sulfonated-EPDM, styrene-butadiene rubber, nitrile-butadiene rubber, fluorine rubber, various copolymers thereof, and the like.

The conductive material of the negative electrode active material layer is a component for further improving the conductivity of the negative electrode active material, and may be added in an amount of 10 wt% or less, preferably 5 wt% or less based on the total weight of the negative electrode active material layer. The conductive material is not particularly limited as long as it has conductivity without causing a chemical change in the battery, and for example, graphite such as natural graphite or artificial graphite; carbon black such as acetylene black, Ketjen black, channel black, furnace black, lamp black, and thermal black; conductive fiber such as carbon fiber and metal fiber; fluorinated carbon; metal powder such as aluminum powder and nickel powder; a conductive whisker such as zinc oxide and potassium titanate; a conductive metal oxide such as titanium oxide; and a conductive material such as a polyphenylene derivative, or the like may be used.

The negative electrode may be prepared by applying a composition for forming a negative electrode active material layer, which is prepared by dissolving or dispersing a negative electrode active material, and selectively, a binder and a conductive material in a solvent, on a negative electrode current collector, followed by drying, or may be prepared by casting the composition for forming a negative electrode active material on a separate support, and then laminating a film obtained by peeling the same off from the support on the negative electrode current collector.

The separator is to separate the negative electrode and the positive electrode and to provide a movement path for lithium ions, and any separator may be used without particular limitation as long as it is a separator commonly used in a lithium secondary battery, and particularly, a separator having excellent moisture-retention of an electrolyte as well as low resistance to ion movement in the electrolyte is preferable. Specifically, a porous polymer film, for example, a porous polymer film manufactured using a polyolefin-based polymer such as an ethylene homopolymer, a propylene homopolymer, an ethylene/butene copolymer, an ethylene/hexene copolymer, and an ethylene/methacrylate copolymer, or a laminated structure having two or more layers thereof may be used. Also, a typical porous non-woven fabric, for example, a non-woven fabric formed of glass fiber having a high melting point, polyethylene terephthalate fiber, or the like may be used. Also, a coated separator including a ceramic component or a polymer material may be used to secure heat resistance or mechanical strength, and may be selectively used in a single-layered or a multi-layered structure.

The electrolyte may be an organic liquid electrolyte, an inorganic liquid electrolyte, a solid polymer electrolyte, a gel-type polymer electrolyte, a solid inorganic electrolyte, a molten-type inorganic electrolyte, and the like, which may be used in the manufacture of a lithium secondary battery, but is not limited thereto. As a specific example, the electrolyte may include an organic solvent and a lithium salt.

As the organic solvent, any organic solvent may be used without particular limitation as long as it can serve as a medium through which ions involved in an electrochemical reaction of a battery may move. Specifically, as the organic solvent, an ester-based solvent such as methyl acetate, ethyl acetate, $\gamma$-butyrolactone, and $\varepsilon$-caprolactone; an ether-based solvent such as dibutyl ether or tetrahydrofuran; a ketone-based solvent such as cyclohexanone; an aromatic hydrocarbon-based solvent such as benzene and fluorobenzene; a carbonate-based solvent such as dimethyl carbonate (DMC), diethyl carbonate (DEC), ethylmethyl carbonate (EMC), ethylene carbonate (EC), and propylene carbonate (PC); an alcohol-based solvent such as ethyl alcohol and isopropyl alcohol; nitriles such as R-CN (wherein R is a linear, branched, or cyclic C2 to C20 hydrocarbon group and may include a double-bond aromatic ring or ether bond); amides such as dimethylformamide; dioxolanes such as 1,3-dioxolane; or sulfolanes may be used. Among these, the carbonate-based solvent is preferred, and a mixture of a cyclic carbonate (e.g., ethylene carbonate or propylene carbonate) having high ion conductivity and a high dielectric constant, which may increase charge/discharge performance of the battery, and a low-viscosity linear carbonate-based compound (e.g., ethylmethyl carbonate, dimethyl carbonate, diethyl carbonate, or the like) is more preferred.

As the lithium salt, any compound may be used without particular limitation as long as it can provide lithium ions used in a lithium secondary battery. Specifically, anions of the lithium salt may be at least one selected from the group consisting of $F^-$, $Cl^-$, $Br^-$, $I^-$, $NO_3^-$, $N(CN)_2^-$, $BF_4^-$, $CF_3CF_2SO_3^-$, $(CF_3SO_2)_2N^-$, $(FSO_2)_2N^-$, $CF_3CF_2(CF_3)_2CO^-$, $(CF_3SO_2)_2CH^-$, $(SF_5)_3C^-$, $(CF_3SO_2)_3C^-$, $CF_3(CF_2)_7SO_3^-$, $CF_3CO_2^-$, $CH_3CO_2^-$, $SCN^-$, and $(CF_3CF_2SO_2)_2N^-$, and as the lithium salt, $LiPF_6$, $LiClO_4$, $LiAsF_6$, $LiBF_4$, $LiSbF_6$, $LiAlO_4$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2$, LiCl, LiI, $LiB(C_2O_4)_2$, or the like may be used. The lithium salt may be used in a concentration range of 0.1 M to 2.0 M. If the concentration of the lithium salt is included in the above-described range, the electrolyte has suitable conductivity and viscosity, and thus, may exhibit excellent electrolyte performance, and lithium ions may effectively move.

In order to improve lifespan of a battery, suppress a decrease in battery capacity, improve discharge capacity of the battery, and the like, the electrolyte may further include one or more kinds of additives, for example, a halo-alkylene carbonate-based compound such as difluoroethylene carbonate, pyridine, triethylphosphite, triethanolamine, cyclic ether, ethylenediamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, aluminum trichloride, and the like. At this time, the additive may be included in an amount of 0.1 wt% to 5 wt% with respect to the total weight of the electrolyte.

A lithium secondary battery including the above-described positive electrode active material according to the present invention has excellent performance, and thus, is useful for portable devices such as a mobile phone, a notebook computer, and a digital camera, and in the field of electric cars such as a hybrid electric vehicle (HEV).

The external shape of the lithium secondary battery of the present invention is not particularly limited, but may be a cylindrical shape using a can, a square shape, a pouch shape, a coin shape, or the like.

The lithium secondary battery according to the present invention may be used in a battery cell which is used as a power source for a small-sized device, and may also be preferably used as a unit cell for a medium- and large-sized battery module including a plurality of battery cells.

Accordingly, a battery module including the lithium secondary battery as a unit cell, and a battery pack including the battery module are provided.

The battery module or the battery pack may be used as a power source for a power tool, an electric car including an electric vehicle (EV), a hybrid electric vehicle, and a plug-in hybrid electric vehicle (PHEV), or one or more medium-to-large devices in a system for power storage.

## MODE FOR CARRYING OUT THE INVENTION

Hereinafter, embodiments of the present invention will be described in detail so that those skilled in the art may easily carry out the present invention. However, the present invention may be embodied in many different forms, and is not limited to the embodiments set forth herein.

### Examples and Comparative Examples

### Example 1

A composite transition metal hydroxide (composition: $Ni_{0.60}Co_{0.05}Mn_{0.35}(OH)_2$, $D_{50}$: 3.5 $\mu$m) in the form of a secondary particle formed by aggregation of tens to hundreds of primary particles, and $Li_2CO_3$ were introduced into an acoustic mixer such that a ratio ((Ni+Co+Mn):Li) of the total number of moles of transition metals (Ni+Co+Mn) included in the composite transition metal hydroxide to the number of moles of lithium (Li) included in $Li_2CO_3$ was to be 1:1.05, and sequentially mixed at 40 g (g: gravitational acceleration) for 2 minutes, at 80 g for 1 minute, and at 50 g for 2 minutes to prepare a mixture.

The mixture was introduced into a circular alumina crucible (75 mm×75 mm), subjected to primary firing at 850 °C for 4 hours under an atmospheric atmosphere, and then subjected to secondary firing at 950 °C for 14 hours after the temperature was continuously raised to 950 °C (temperature raising rate: 10 °C/min) to prepare a fired product.

The fired product was finely pulverized under 3.5 bar at a rate of 12 g/min by using a jet mill (Air Jet Mill, Isaac ENC Co., Ltd.) to prepare a positive electrode active material.

### Example 2

The mixture prepared in Example 1 was introduced into a circular alumina crucible (75 mm×75 mm), subjected to primary firing at 850 °C for 4 hours under an atmospheric atmosphere, and then subjected to secondary firing at 940 °C for 14 hours after the temperature was continuously raised to 940 °C (temperature raising rate: 10 °C/min) to prepare a fired product.

The fired product was finely pulverized under 3.5 bar at a rate of 12 g/min by using a jet mill (Air Jet Mill, Isaac ENC Co., Ltd.) to prepare a positive electrode active material.

### Comparative Example 1

The mixture prepared in Example 1 was introduced into a circular alumina crucible (75 mm×75 mm), and then fired at 950 °C for 14 hours under an atmospheric atmosphere to prepare a fired product.

The fired product was finely pulverized under 3.5 bar at a rate of 12 g/min by using a jet mill (Air Jet Mill, Isaac ENC Co., Ltd.) to prepare a positive electrode active material.

### Comparative Example 2

The mixture prepared in Example 1 was introduced into a circular alumina crucible (75 mm×75 mm), subjected to primary firing at 950 °C for 14 hours under an atmospheric atmosphere, and then subjected to secondary firing at 850 °C for 4 hours after the temperature was continuously lowered to 850 °C (temperature lowering rate: 10 °C/min) to prepare a fired product.

The fired product was finely pulverized under 3.5 bar at a rate of 12 g/min by using a jet mill (Air Jet Mill, Isaac ENC Co., Ltd.) to prepare a positive electrode active material.

### Experimental Examples

**Experimental Example 1: (1) Analysis of positive electrode active material**

An SEM (FEI Co., Ltd., Inspect F) was used to obtain an SEM image of each of the positive electrode active materials prepared in Examples and Comparative Examples, and an image processing program (LG Chemical Co., Ltd., DX program) was used to divide boundaries of primary particles present in the SEM image, thereby obtaining images shown in random colors.

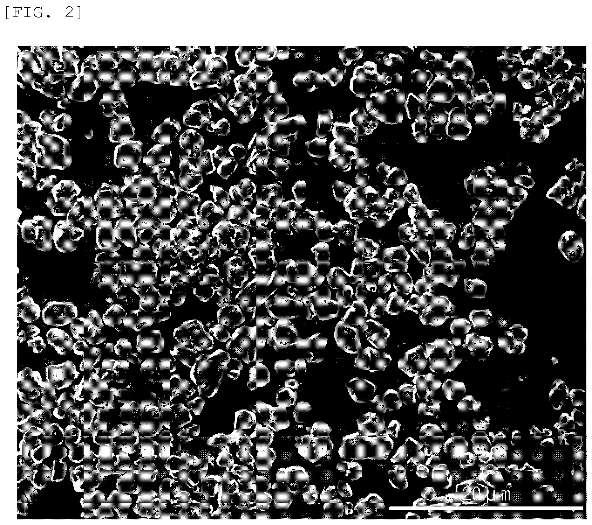

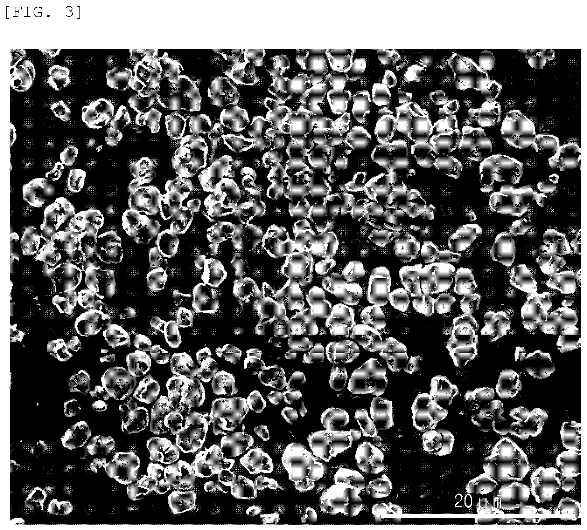

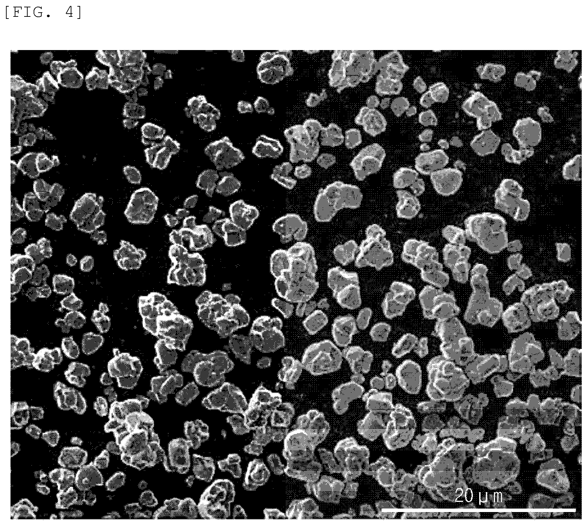

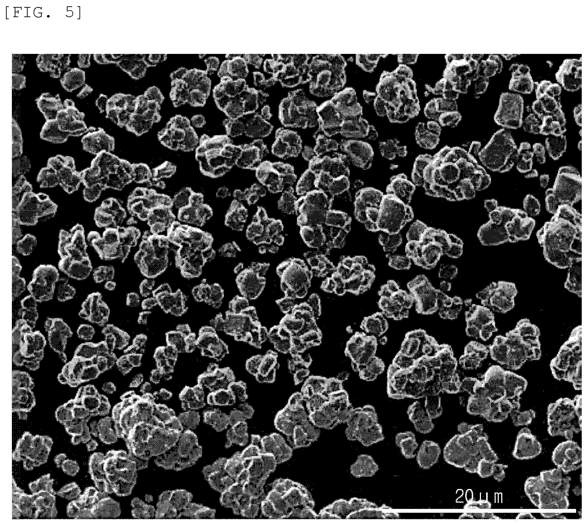

Meanwhile, the SEM images of the positive electrode active materials of Examples 1 and 2 and Comparative Examples 1 and 2 are respectively shown in FIG. 2 (Example 1), FIG. 3 (Example 2), FIG. 4 (Comparative Example 1), and FIG. 5 (Comparative Example 2). Referring to FIG. 2 and FIG. 3, it can be confirmed that the positive electrode active materials of Examples 1 and 2 are in the form of a single particle.

The images shown in random colors obtained by dividing the boundaries of the primary particles were used to calculate the area of each of the primary particles was calculated through the number of pixels corresponding to each of n primary particles (on average 50,000 or more primary particles), a radius ($r_i$) of a circle having the same area as the area of each of the primary particles was used to calculate a particle diameter ($D_i=2r_i$) and a volume ($V_i=4/3\times\pi r_i^3$) of each of the primary particles present in the SEM image, the total sum of values ($V_iD_i$) obtained by multiplying the volume and the particle diameter calculated for each primary particle was divided by the total sum of the volumes ($V_i$) calculated to derive a volume average particle diameter of the primary particles, the total sum of the calculated particle diameters was divided by the number of the primary particle to derive a number-average particle diameter, and then a PDI value was obtained according to Equation 1 described in the present invention, all of which are shown in Table 1 below.

**Experimental Example 2: (2) Analysis of positive electrode active material**

0.01 g of each of the positive electrode active materials (powder) prepared in Examples and Comparative Examples was taken, placed in a vial containing 30 ml of ultrapure water and 500 µl of a dispersant, thereby dispersing the positive electrode active material for 1 minute using a sonicator, and then placed in a PSA (Microtrac Co., Ltd., S3500) to be analyzed, thereby confirming $D_{50}$, which is shown in Table 1 below.

At this time, the $D_{50}$ means a particle diameter at a point of 50% in a volume cumulative distribution according to a particle diameter.

**Experimental Example 3: Evaluation of amount of fine particle generation**

3 g of each of the positive electrode active materials (powder) prepared in Examples and Comparative Examples was taken, and then placed in a mold having an inner diameter of 13 mm and pressed at 9 tons for 1 minute, followed by confirming the number of particles having a particle diameter of less than 1 µm by using a PSA (Microtrac Co., Ltd., S3500). In addition, a ratio (amount of fine particle generation) of the number of particles having a particle diameter of less than 1 µm with respect to the total number of particles was calculated and is shown in Table 1 below.

[Table 1]

| Classification | Volume average particle diameter of primary particles (µm) | Number-average particle diameter of primary particles (µm) | PDI | $D_{50}$ (µm) as measured by using PSA | Amount of fine particle generation (%) |
|---|---|---|---|---|---|
| Example 1 | 2.347 | 1.393 | 1.685 | 4.20 | 1.11 |
| Example 2 | 2.578 | 1.577 | 1.635 | 4.39 | 0.42 |
| Comparative Example 1 | 2.024 | 1.082 | 1.871 | 3.86 | 2.76 |
| Comparative Example 2 | 2.062 | 1.026 | 2.011 | 4.21 | 4.39 |

Referring to Table 1 above, the positive electrode active materials of Examples 1 and 2 have a PDI value closer to 1, and thus, are confirmed to have a uniform particle diameter of primary particles compared and the positive electrode active materials of Comparative Examples 1 and 2. In addition, it can be confirmed that the positive electrode active materials of Examples 1 and 2 have a small amount of fine particle generation.

It is expected that in the positive electrode active materials of Comparative Examples 1 and 2, primary particles grew before lithium melted and evenly spread, so that some particles overgrew due to excessive lithium therein, and other particles grew small due to insufficient lithium, resulting in non-uniform growth.

**Experimental Example 4: Evaluation of battery performance**

**(1) Evaluation of volume change rate**

Each of the positive electrode active materials prepared in Examples and Comparative Examples, a carbon black conductive material, and a polyvinylidene fluoride (PVDF) binder were mixed at a weight ratio of 95:2:3 in an N-methylpyrrolidone (NMP) solvent to prepare a positive electrode slurry. The positive electrode slurry was applied on one surface of an aluminum current collector, dried at 130 °C, and then roll-pressed to manufacture a positive electrode.

A negative electrode active material in which natural graphite and artificial graphite were mixed at a weight ratio of 5:5, a Super C conductive material, a binder (ZEON Co., Ltd., BML302), and an additive (Daicel Co., Ltd., DAICEL2200) were mixed at a weight ratio of 95.6:1.0:2.3:1.1 in water to prepare a negative electrode slurry. The negative electrode slurry was applied on one surface of a copper current collector, dried at 130 °C, and then roll-pressed to manufacture a negative electrode.

A porous polyethylene separator was interposed between the positive electrode and the negative electrode manufactured above to prepare an electrode assembly, and the electrode assembly was laminated at 80 °C to properly bond the electrodes, welded with aluminum and nickel tabs, and then placed in an aluminum pouch, into which an electrolyte solution was injected to manufacture a mono-cell. At this time, as the electrolyte solution, an electrolyte solution prepared by dissolving 0.7 M of $LiPF_6$ in an organic solvent in which ethylene carbonate (EC) and ethylmethyl carbonate (EMC) were mixed at a volume ratio of 3:7 was used.

For each of the mono-cells manufactured as described above, charging formation was performed at a constant current of 0.1 C at 25 °C for 3 hours, and then one side of the pouch was opened to perform vacuum degassing and re-sealed. Thereafter, charging and discharging were repeated three times with a constant current of 0.33 C, and then charging was performed with a constant current of 0.33 C. The charged mono-cell was opened to separate the negative electrode, and then two of each of the positive electrode and the separator were alternately stacked, placed in an aluminum pouch, and an electrolyte solution was injected into the pouch to manufacture a cell for volume measurement. At this time, as the electrolyte solution, an electrolyte solution prepared by dissolving 0.7 M of $LiPF_6$ in an organic solvent in which ethylene carbonate (EC):ethylmethyl carbonate (EMC) were mixed at a volume ratio of 3:7 was used.

After the initial volume of the cell for volume measurement was measured, the cell for volume measurement was stored in an oven at 60 °C for 8 weeks, and then the cell volume after 8 weeks was measured, and the volume change rate ([(initial volume) - (cell volume after 8 weeks)]/(initial volume) × 100) was calculated, and the results are shown in Table 2 below.

**(2) Evaluation of capacity retention rate**

Each of the positive electrode active materials prepared in Examples and Comparative Examples, a carbon black conductive material, and a polyvinylidene fluoride (PVDF) binder were mixed at a ratio of 95:2:3 in an N-methylpyrrolidone (NMP) solvent to prepare a positive electrode slurry. The positive electrode slurry was applied on one surface of an aluminum current collector, dried at 130 °C, and then roll-pressed to manufacture a positive electrode.

A lithium metal electrode was used as a negative electrode, and a porous polyethylene separator was interposed between the positive electrode and the negative electrode to prepare an electrode assembly, and the electrode assembly was placed inside a battery case, followed by injecting an electrolyte solution into the battery case to manufacture a half-cell. At this time, the electrolyte solution was prepared by dissolving 1.0 M of $LiPF_6$ in an organic solvent in which ethylene carbonate (EC):ethyl methyl carbonate (EMC):dimethyl carbonate (DMC) were mixed at a volume ratio of 3:3:4.

Each of the half-cells manufactured as described above was charged (0.5 C) to 4.45 V at 45 °C in a CC-CV manner and then discharged (1 C) to 2.5 V in a CC manner, which was set to one cycle, and a total of 50 cycles were repeatedly performed thereon to measure the capacity of a lithium secondary battery, and the percentage of the 50-th cycle discharge capacity with respect to the first cycle discharge capacity was set to a capacity retention rate, which is shown in Table 2 below.

[Table 2]

| Classificat ion | Volume change rate (%) (@ 8-week high-temperature storage) | Capacity retention rate (%) (@ 50 cycles) |
|---|---|---|
| Example 1 | 22.46 | 93.1 |
| Example 2 | 22.80 | 92.9 |
| Comparative Example 1 | 24.54 | 91.2 |

(continued)

| Classificat ion | Volume change rate (%) (@ 8-week high-temperature storage) | Capacity retention rate (%) (@ 50 cycles) |
|---|---|---|
| Comparative Example 2 | 26.30 | 89.4 |

Referring to Table 1 and Table 2 above, the positive electrode active material of each of Examples 1 and 2 has a PDI value closer to 1, and has a small number of fine particles generated, so that a battery including the positive electrode active material is confirmed to have a reduced volume change due to gas generation and an increased capacity retention rate compared to a battery including the positive electrode active material of each of Comparative Examples 1 and 2.

As a result, according to the method for preparing a positive electrode active material of the present invention, if a mixture including a positive electrode active material precursor and a lithium-containing raw material is subjected to primary firing at 600 °C to 900 °C, continuously heated to 920 °C to 1000 °C, and then subjected to secondary firing at 920 °C to 1000 °C, it can be seen that a positive electrode active material in the form of a single particle having a uniform particle diameter of primary particles is prepared, and there is a small amount of fine particles. In addition, the positive electrode active material according to the present invention includes a lithium nickel cobalt manganese-based oxide in the form of a single particle having a nickel content of 50 mol% or greater among all transition metals, and has a PDI value satisfying 1 to 1.8, so that it can be seen that both high-temperature stability and lifespan performance of a lithium secondary battery may be improved.

**Claims**

1.  A positive electrode active material comprising a lithium nickel cobalt manganese-based oxide having a nickel content of 50 mol% or greater among all transition metals, and in the form of a single particle composed of 10 or fewer primary particles,
    wherein the positive electrode active material has a polydispersity index (PDI) value of 1 to 1.8 according to Equation 1 below:

    PDI = Volume average particle diameter ($\mu$m) of primary particles /Number-average particle diameter ($\mu$m) of primary particles          [Equation 1]

2.  The positive electrode active material of claim 1, wherein the lithium nickel cobalt manganese-based oxide has a composition represented by Formula 1 below:

    [Formula 1]          $Li_{1+x}Ni_{a1}Co_{b1}Mn_{c1}M^1_{d1}O_2$

    wherein in Formula 1 above, $M^1$ is one or more selected from Al, W, Co, B, Zr, Y, Ce, Hf, La, Ba, F, P, S, Nb, Ta, Sc, Cr, V, Cu, Sr, Ti, Mg, Mo, Sn, Fe, Zn, and Si, and $-0.1 \leq x \leq 0.1$, $0.5 \leq a1 < 1$, $0 < b1 < 0.5$, $0 < c1 < 0.5$, $0 \leq d1 \leq 0.2$, and $a1+b1+c1+d1=1$.

3.  The positive electrode active material of claim 1, wherein the primary particles have a volume average particle diameter of 0.5 $\mu$m to 3.5 $\mu$m.

4.  The positive electrode active material of claim 1, wherein the primary particles have a number-average particle diameter of 0.5 $\mu$m to 2.0 $\mu$m.

5.  The positive electrode active material of claim 1, wherein the positive electrode active material has a $D_{50}$ of 3 $\mu$m to 5 $\mu$m as measured by using a particle size analyzer (PSA).

6.  The positive electrode active material of claim 1, wherein a ratio of the number of particles having a particle diameter of less than 1 $\mu$m as measured by a PSA (particle size analyzer) with respect to the total number of particles after placing 3 g of the positive electrode active material in a mold having an inner diameter of 13 mm, and then pressing the same at 9 tons for 1 minute is 2.5% or less.

7.  A method for preparing the positive electrode active material according to claim 1, the method comprising:

(A) mixing a nickel cobalt manganese-based hydroxide having a nickel content of 50 mol% or greater among all transition metals and a lithium-containing raw material, thereby preparing a mixture; and
(B) under an atmospheric atmosphere, subjecting the mixture to primary firing at 600 °C to 900 °C, continuously heating the mixture to 920 °C to 1000 °C, and then subjecting the mixture to secondary firing at 920 °C to 1000 °C, thereby preparing a fired product.

8. The method of claim 7, wherein the nickel cobalt manganese-based hydroxide has a composition represented by Formula 2 below:

$$[Formula\ 2] \qquad Ni_{a2}Co_{b2}Mn_{c2}M^2_{d2}(OH)_2$$

wherein in Formula 2 above,

$M^2$ is one or more selected from Al, W, Co, B, Zr, Y, Ce, Hf, La, Ba, F, P, S, Nb, Ta, Sc, Cr, V, Cu, Sr, Ti, Mg, Mo, Sn, Fe, Zn, and Si, and
$0.5 \leq a2 < 1$, $0 < b2 < 0.5$, $0 < c2 < 0.5$, $0 \leq d2 \leq 0.2$, and $a2+b2+c2+d2=1$.

9. The method of claim 7, wherein the primary firing is performed for 2 hours to 12 hours.

10. The method of claim 7, wherein the secondary firing is performed for 4 hours to 14 hours.

11. The method of claim 7, further comprising (C) finely pulverizing the fired product.

12. The method of claim 11, wherein the fine pulverization is performed by vortex flow-type pulverization.

13. The method of claim 12, wherein the vortex flow-type pulverization is performed under a pressure of 1 bar to 5 bar.

14. A positive electrode comprising the positive electrode active material according to any one of claim 1 to claim 6.

15. A lithium secondary battery comprising:

the positive electrode according to claim 14;
a negative electrode;
a separator interposed between the positive electrode and the negative electrode; and
an electrolyte.

[FIG. 1]

[FIG. 2]

[FIG. 3]

[FIG. 4]

[FIG. 5]

## INTERNATIONAL SEARCH REPORT

| International application No. |
| --- |
| **PCT/KR2024/017099** |

| A. | CLASSIFICATION OF SUBJECT MATTER |
| --- | --- |

**H01M 4/525**(2010.01)i; **H01M 4/505**(2010.01)i; **C01G 53/00**(2006.01)i; **H01M 10/0525**(2010.01)i; **H01M 4/02**(2006.01)i

According to International Patent Classification (IPC) or to both national classification and IPC

| B. | FIELDS SEARCHED |
| --- | --- |

Minimum documentation searched (classification system followed by classification symbols)

H01M 4/525(2010.01); H01M 10/052(2010.01); H01M 4/131(2010.01); H01M 4/485(2010.01); H01M 4/505(2010.01); H01M 50/446(2021.01); H01M 50/451(2021.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 리튬 이차전지(lithium secondary battery), 양극 활물질(cathode active material), 단입자(single particle), 입경(particle size), 소성(calcination), 부피평균 입경(volume average particle size), 수평균 입경(number average particle size)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | KR 10-2023-0098072 A (LG ENERGY SOLUTION, LTD.) 03 July 2023 (2023-07-03)<br>See claims 1, 6-8 and 13-15; and paragraphs [0045], [0058], [0066]-[0078], [0080], [0081], [0093], [0113], [0116], [0167], [0168] and [0207]-[0210]. | 1-15 |
| Y | CN 115483393 A (SUNWODA ELECTRIC VEHICLE CELL CO., LTD.) 16 December 2022 (2022-12-16)<br>See claims 1-3; and paragraphs [0005]-[0007] and [0030]. | 1-15 |
| Y | KR 10-2019-0060705 A (LG CHEM, LTD.) 03 June 2019 (2019-06-03)<br>See claim 1; and paragraphs [0025], [0058], [0063]-[0067] and [0078]. | 7-13 |
| A | US 2022-0052338 A1 (CONTEMPORARY AMPEREX TECHNOLOGY CO., LIMITED) 17 February 2022 (2022-02-17)<br>See abstract; and claims 1-14. | 1-15 |

☑ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **10 February 2025** | **10 February 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

International application No.

**PCT/KR2024/017099**

### C. DOCUMENTS CONSIDERED TO BE RELEVANT

| Category* | Citation of document, with indication, where appropriate, of the relevant passages | Relevant to claim No. |
|---|---|---|
| A | KR 10-2021-0042404 A (NINGDE AMPEREX TECHNOLOGY LIMITED) 19 April 2021 (2021-04-19)<br>See abstract; and claims 1-10. | 1-15 |

Form PCT/ISA/210 (second sheet) (July 2022)

## INTERNATIONAL SEARCH REPORT
### Information on patent family members

| International application No. |
|---|
| **PCT/KR2024/017099** |

| Patent document cited in search report | | | Publication date (day/month/year) | Patent family member(s) | | | Publication date (day/month/year) |
|---|---|---|---|---|---|---|---|
| KR | 10-2023-0098072 | A | 03 July 2023 | CN | 118339677 | A | 12 July 2024 |
| | | | | EP | 4425611 | A1 | 04 September 2024 |
| | | | | JP | 2024-546664 | A | 26 December 2024 |
| | | | | US | 2023-0207799 | A1 | 29 June 2023 |
| | | | | WO | 2023-121389 | A1 | 29 June 2023 |
| CN | 115483393 | A | 16 December 2022 | None | | | |
| KR | 10-2019-0060705 | A | 03 June 2019 | CN | 110650923 | A | 03 January 2020 |
| | | | | CN | 110650923 | B | 08 March 2022 |
| | | | | EP | 3611132 | A2 | 19 February 2020 |
| | | | | EP | 3611132 | A4 | 22 July 2020 |
| | | | | EP | 3611132 | B1 | 01 September 2021 |
| | | | | JP | 2021-501980 | A | 21 January 2021 |
| | | | | JP | 2022-111183 | A | 29 July 2022 |
| | | | | KR | 10-2177799 | B1 | 12 November 2020 |
| | | | | US | 2020-0350554 | A1 | 05 November 2020 |
| | | | | WO | 2019-103522 | A2 | 31 May 2019 |
| | | | | WO | 2019-103522 | A3 | 18 July 2019 |
| US | 2022-0052338 | A1 | 17 February 2022 | CN | 110518232 | A | 29 November 2019 |
| | | | | CN | 110518232 | B | 15 December 2020 |
| | | | | CN | 112436134 | A | 02 March 2021 |
| | | | | CN | 112436134 | B | 08 March 2022 |
| | | | | EP | 3951946 | A1 | 09 February 2022 |
| | | | | EP | 3951946 | A4 | 15 June 2022 |
| | | | | EP | 3951946 | B1 | 30 November 2022 |
| | | | | EP | 4148830 | A2 | 15 March 2023 |
| | | | | EP | 4148830 | A3 | 05 April 2023 |
| | | | | EP | 4148830 | B1 | 09 August 2023 |
| | | | | ES | 2934943 | T3 | 28 February 2023 |
| | | | | US | 12176534 | B2 | 24 December 2024 |
| | | | | US | 2023-0246184 | A1 | 03 August 2023 |
| | | | | WO | 2020-220662 | A1 | 05 November 2020 |
| KR | 10-2021-0042404 | A | 19 April 2021 | CN | 111916624 | A | 10 November 2020 |
| | | | | CN | 111916624 | B | 01 February 2022 |
| | | | | EP | 3758097 | A1 | 30 December 2020 |
| | | | | EP | 3758097 | A4 | 16 June 2021 |
| | | | | JP | 2022-501784 | A | 06 January 2022 |
| | | | | JP | 7195414 | B2 | 23 December 2022 |
| | | | | KR | 10-2608006 | B1 | 01 December 2023 |
| | | | | US | 2021-0234233 | A1 | 29 July 2021 |
| | | | | US | 2023-0261322 | A1 | 17 August 2023 |
| | | | | WO | 2020-224319 | A1 | 12 November 2020 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230151125